# DEMANDE DE BREVET EUROPEEN

(11) **EP 1 650 796 A2**
(43) Date de publication de la demande: **26.04.2006**
(21) Numéro de dépôt: 05292061.8
(22) Date de dépôt: 04.10.2005
(51) Int. Cl.: H01L 21/768, H01L 23/485

(54) **Procédé de prise de contact sur une région d'un circuit intégré, en particulier sur les électrodes d'un transistor**

(30) Priorité: 20.10.2004 FR 0411123
(71) Demandeur: STMicroelectronics ( Crolles 2) SAS, 38920 Crolles (FR); STMicroelectronics SA, 92120 Montrouge (FR)
(72) Inventeur: Lenoble, Damien, 38610 Gieres (FR); Coronel, Philippe, 38530 Barraux (FR); Cerutti, Robin, 38100 Grenoble (FR)
(74) Mandataire: Zapalowicz, Francis

(57) **Abrégé**

On modifie localement ladite région (51) de façon à créer une zone (510) s'étendant jusqu'à une partie au moins de la surface de ladite région et formée d'un matériau sélectivement éliminable par rapport au matériau de ladite région, on recouvre ladite région avec un matériau isolant (7), on forme dans le matériau isolant un orifice (90) débouchant à la surface de ladite zone, on élimine le matériau sélectivement éliminable de ladite zone à travers ledit orifice de façon à former une cavité (520) à la place de ladite zone, et on remplit ladite cavité et ledit orifice avec au moins un matériau électriquement conducteur (91).

## Description

La présente invention concerne les circuits intégrés, notamment leur fabrication, et plus particulièrement la prise de contact sur une région du circuit intégré.

Une prise de contact sur une région d'un circuit intégré, par exemple sur la région de source, de drain ou de grille d'un transistor, ou bien sur une ligne de polysilicium formant une résistance, consiste généralement actuellement en une siliciuration (c'est-à-dire une formation d'un siliciure de métal) de la partie supérieure de ladite région puis après avoir déposé un matériau isolant sur ladite région, par exemple du dioxyde de silicium, à ouvrir un orifice, communément appelé « via » par l'homme du métier, et à remplir le via d'un métal qui va venir au contact de la zone siliciurée. Ce via va ainsi permettre une connexion électrique entre la région semi-conductrice siliciurée et un niveau de métallisation du circuit intégré.

Un tel procédé présente de nombreux inconvénients. Parmi ceux-ci, on peut citer par exemple la complexité et le coût de réalisation, mais également le problème de la résistance de la couche de siliciure ainsi que le problème de l'interface entre le siliciure de métal et le silicium. En effet, si cette interface n'est pas correcte, il peut en résulter un perçage des jonctions, une augmentation de la résistance, ou encore un décollement du siliciure de métal. L'interface entre zone siliciurée et le métal remplissant le via doit être parfaitement contrôlé. Aussi, est-il nécessaire alors de prévoir un nettoyage des fonds de contact après l'ouverture des vias, de façon à minimiser les risques d'obtenir une interface de mauvaise qualité. Et par conséquent, ceci augmente encore la complexité et le coût de réalisation.

L'invention vise à remédier à ces inconvénients.

Un but de l'invention est de proposer une réalisation d'une prise de contact qui soit radicalement différente de celle actuellement utilisée dans l'art antérieur.

L'invention a pour but de proposer une réalisation d'une prise de contact qui soit extrêmement simple à effectuer avec un rendement très bon, en s'affranchissant notamment du nettoyage des fonds de contact effectué dans l'art antérieur.

L'invention a encore pour but de proposer une prise de contact présentant une résistance très faible et en tout cas plus faible que celle obtenue dans l'art antérieur par siliciuration.

L'invention a encore pour but de diminuer la résistance de contact associée et ce sans augmenter l'ouverture du via, afin de préserver la densité d'intégration des interconnexions.

Selon un aspect de l'invention, il est proposé un procédé de réalisation d'au moins une prise de contact sur au moins une région d'un circuit intégré, dans lequel on modifie localement ladite région de façon à créer une zone s'étendant jusqu'à une partie au moins de la surface de ladite région, cette zone étant formée d'un matériau sélectivement éliminable par rapport au matériau de ladite région. On recouvre ladite région avec un matériau isolant et on forme dans le matériau isolant un orifice débouchant à la surface de ladite zone. On élimine le matériau sélectivement éliminable de ladite zone à travers ledit orifice de façon à former une cavité à la place de ladite zone. Et on remplit ladite cavité et ledit orifice avec au moins un matériau électriquement conducteur, par exemple métallique. On peut ainsi obtenir une prise de contact par exemple entièrement métallique sur ladite région.

Selon cet aspect, l'invention prévoit ainsi en particulier la réalisation simultanée d'une métallisation sur la région semi-conductrice du circuit intégré, et du via d'interconnexion permettant de connecter cette métallisation à un niveau de métallisation supérieure du circuit intégré. Ceci est particulièrement simple à réaliser à moindre coût. Les rendements sont très bons car le choix des matériaux électriquement conducteurs et de la température est très vaste. A cet égard, on peut envisager, non limitativement, de remplir la cavité et l'orifice de gravure avec un seul et même métal, mais aussi avec plusieurs métaux ou composés métalliques différents, ou encore avec un ou plusieurs oxydes métalliques, comme par exemple un oxyde d'indium tel que celui connu de l'homme du métier sous la dénomination anglosaxonne ITO (Indium Thin Oxide).

Par ailleurs, le problème du nettoyage des fonds de contact après l'ouverture des vias ne se pose pas ici car selon un mode de mise en oeuvre de l'invention, on prévoit l'élimination d'une couche de matériau sélectivement éliminable et, de ce fait, l'interface ainsi obtenue est quasi parfaite.

Par ailleurs, la couche métallisée située en surface de la région sur laquelle on prend le contact, peut présenter une résistance très faible, et en tout cas plus faible que celle d'un siliciure de métal.

Par ailleurs l'épaisseur de cette couche métallisée est parfaitement déterminable et peut être aisément ajustée en fonction de l'application envisagée.

En outre, la métallisation se fait à un instant tardif dans le procédé de réalisation des composants sur lesquels il est nécessaire de prendre un contact métallique. De ce fait, le bilan thermique est plus faible. Les jonctions peuvent être réalisées en surface sur une très faible profondeur parce que le bilan thermique est faible et parce que la métallisation de la jonction peut être effectuée sur une très faible épaisseur.

Par ailleurs, selon un mode de mise en oeuvre particulièrement avantageux de l'invention, l'ouverture de la cavité est plus grande que celle dudit orifice, ce qui permet d'augmenter la surface du contact électriquement conducteur (c'est-à-dire la zone remplie du matériau électriquement conducteur) et par conséquent de diminuer la résistance de contact et ce sans augmenter les dimensions du via, c'est-à-dire celles de l'orifice. On préserve donc la densité d'intégration des interconnexions. Et ceci est rendu possible car la définition de l'emplacement et des dimensions de la cavité est effectuée avant la gravure de l'orifice et que la formation effective de la cavité est effectuée après ladite gravure et à travers l'orifice gravé.

L'invention s'applique en particulier pour des prises de contact sur des régions de composants actifs, tels que des transistors, ou bien passifs, tels que des résistances, par exemple des lignes résistives en polysilicium. L'invention permet ainsi en particulier de diminuer les résistances d'accès à toutes sortes de dispositifs, en particulier les transistors bipolaires.

L'invention peut également s'appliquer à tout élément, passif ou actif d'un circuit intégré sur lequel il est nécessaire de prendre un contact.

L'épaisseur de la zone résultant de la modification locale de ladite région peut avoir une épaisseur quelconque, que l'homme du métier saura choisir en fonction de l'application envisagée. Cela étant, il est particulièrement avantageux que la zone soit une zone surfacique très fine, ce qui est aisément rendu possible par un mode de mise en oeuvre du procédé selon l'invention. A cet égard, l'épaisseur de ladite zone surfacique est par exemple inférieure à 50 nm

Le matériau de ladite région sur laquelle on souhaite prendre le contact, est par exemple un matériau à base de silicium, par exemple du silicium mono cristallin ou poly cristallin. Dans ce cas, le matériau sélectivement éliminable peut être un alliage de silicium et de germanium.

On forme par exemple ladite zone par implantation de dopants, par exemple par implantation de germanium, cette implantation pouvant être par exemple localisée par un masquage de resine ou bien auto-alignée sur un motif préexistant d'un circuit intégré. Il serait égament possible dans certains cas d'implanter de l'oxygène ou de l'azote.

On peut former ledit orifice dans le matériau isolant par une gravure chimique ou plasma.

Selon un mode de mise en oeuvre, on élimine le matériau de ladite zone par une gravure sélective.

Dans certains cas, toute la surface de la région peut être métallisée. En d'autres termes, selon un tel mode de mise en oeuvre, ladite zone s'étend jusqu'à la totalité de ladite région.

Ladite région peut être une région de source, de drain, ou de grille d'un transistor à effet de champ, ou une région d'émetteur, de collecteur ou de base d'un transistor bipolaire.

Lorsque l'invention s'applique à la fabrication d'un transistor MOS, cette fabrication comprend, selon un mode de mise en oeuvre :
a) la formation des régions de grille, source et drain du transistor, et,
b) la réalisation simultanée des prises de contact métalliques respectives sur les régions de source et de drain telles que définies ci avant. Le matériau isolant dans lequel on forme lesdits orifices débouchant sur les régions de source et de drain recouvre alors la structure obtenue à l'étape a).

Ainsi, il est possible d'obtenir selon un mode de mise en oeuvre de l'invention des métallisations auto alignées sur les régions de source et drain du transistor MOS et ce sans problème de court-circuit des jonctions sous-jacentes.

On peut également réaliser simultanément la métallisation et la prise de contact métallique sur la région de grille.

Ainsi, dans le cas d'un transistor MOS, par exemple, l'invention est remarquable en ce sens que l'on réalise simultanément et de façon auto alignée les métallisations de source de drain et de grille ainsi que les vias interconnectant ces métallisations au niveau de métallisation supérieure du circuit intégré.

Selon un autre aspect de l'invention il est proposé également un circuit intégré comprenant au moins une région équipée d'une prise de contact entièrement métallique obtenue par le procédé tel que défini ci avant.

Cette région peut faire partie d'un composant passif ou actif.

Ce composant peut être ainsi une résistance formée d'une ligne de polysilicium ou bien un transistor obtenu par un procédé de fabrication tel que défini ci avant.

D'autres avantages et caractéristiques de l'invention apparaîtront à l'examen de la description détaillée de modes de réalisation et de mise en oeuvre, nullement limitatifs, et des dessins annexés, sur lesquels :
- les figures 1 à 10 illustrent schématiquement les principales étapes d'un mode de mise en oeuvre du procédé selon la présente invention, et la figure 11 représente schématiquement un transistor obtenu par un tel mode de mise en oeuvre, au sein d'un circuit intégré,et
- la figure 12 illustre schématiquement un autre composant d'un circuit intégré équipé d'une prise de contact selon un mode de réalisation de l'invention.

On va maintenant décrire plus en détails, les principales étapes d'un mode de mise en oeuvre du procédé selon l'invention.

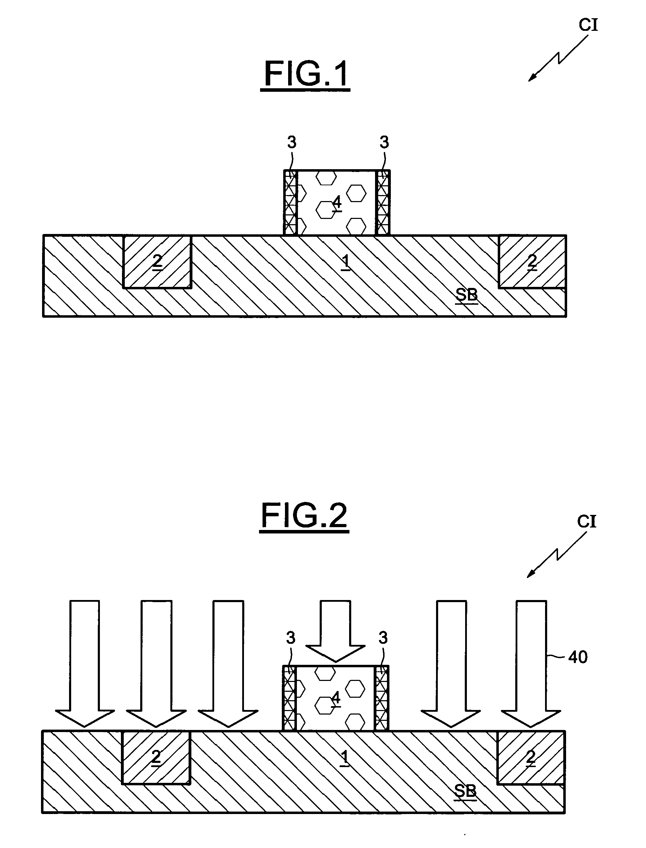

Sur la figure 1, on forme sur un substrat SB, par exemple en silicium, une zone active 1 entre deux zones d'isolation 2, lesdites zones d'isolation pouvant être des tranchées d'isolation. Ces tranchées d'isolation peuvent être, par exemple, profondes de type DTI (« Deep Trench Isolation ») ou peu profondes de type STI (« Shallow Trench Isolation »).

Sur la zone active 1, on réalise une région de grille initiale 4, pouvant également être en polysilicium, par des moyens connus en soi.

On procède ensuite à la matérialisation des régions de source et de drain (figure 2). Cette matérialisation est effectuée, par exemple, en procédant à deux implantations 40 de dopants respectivement effectuées avant et après la formation d'espaceurs 3 entourant la grille. La nature des dopants est choisie en fonction du type N ou P du transistor sur le circuit CI. La grille initiale 4 servant de masque pour les implantations ioniques, on obtient des régions de source et de drain auto-alignées avec la région de grille initiale 4 et avec la zone active 1 délimitée par les régions d'isolations 2.

On procède également à une implantation de dopants dans la grille.

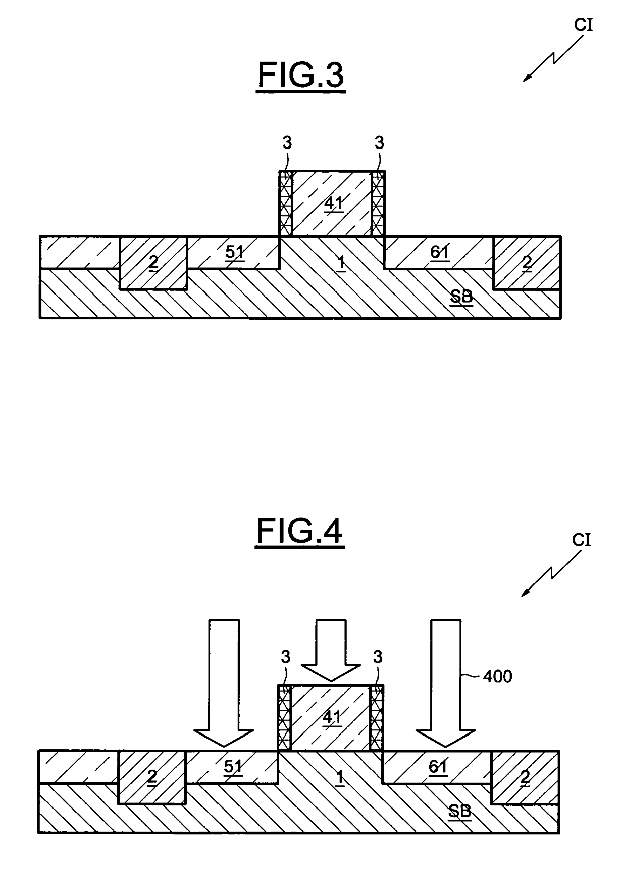

Ces diverses implantations permettent de matérialiser, comme illustré sur la Figure 3, des régions diffusées de source 51, de drain 61, et de grille 41. On notera également bien entendu que la grille du transistor est dans cet exemple une grille isolée, séparée du substrat 1 par un oxyde de grille, non représenté ici à des fins de simplification.

On procède ensuite (Figure 4) à une implantation 400 de germanium par exemple, sur le circuit intégré CI. Cette implantation est donc effectuée « pleine plaque » (« full sheet »).

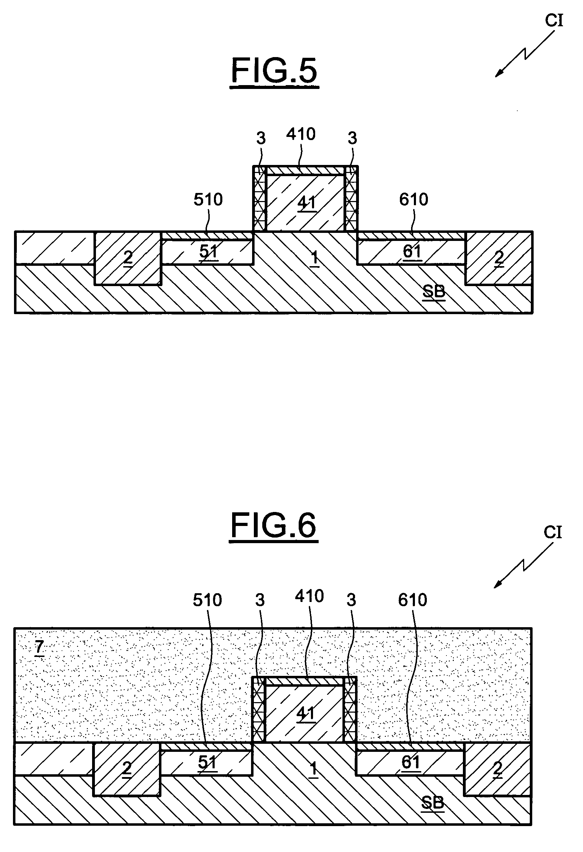

Comme illustré sur la Figure 5, cette implantation 400 a une énergie choisie de façon à former des zones superficielles 410, 510 et 610 et ce, respectivement dans les régions 41, 51 et 61. Ces zones surfaciques 410, 510 et 610 sont alors formées d'un matériau sélectivement éliminable par rapport au silicium formant les régions 41, 51 et 61. Plus précisément, dans le cas présent, ces zones 410, 510 et 610 sont formées d'un alliage de silicium germanium SiGe.

Un recuit peut en outre être effectué de façon à recristalliser les matériaux et ainsi à mieux définir les frontières entre le matériau formant les régions 51, 61 et 41 et le matériau sélectivement éliminable dans les zones de source 510, 610 et 410. Ce recuit peut par exemple être effectué à une température de 800 à 900 °C.

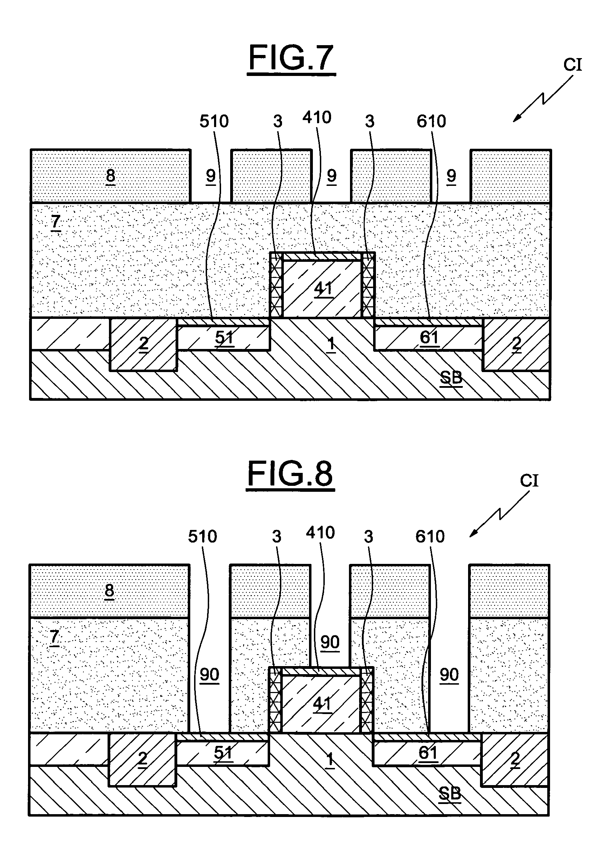

La surface du circuit est ensuite recouverte par des moyens connus, d'une couche d'un matériau isolant 7, ladite couche 7 étant constituée par exemple de dioxyde de silicium (Figure 6). Cette couche 7 est surmontée d'une couche de résine 8 (Figure 7), également obtenue par des moyens connus, dans laquelle on forme de façon connue des orifices 9 matérialisant l'emplacement 9 des futurs vias de connexions.

Puis on procède, à travers les orifices 9 du masque de résine, à une gravure anisotrope du matériau isolant 7 de façon à obtenir des orifices de gravure 90 s'étendant jusqu'aux zones de source 510, de drain 610 et de grille 410 (Figure 8).

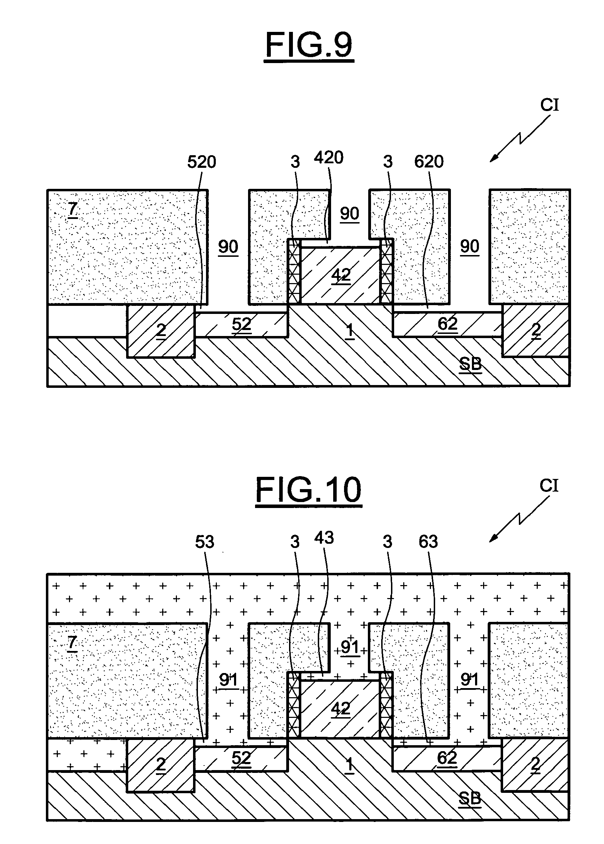

C'est à travers les orifices 90 que le matériau sélectivement éliminable, présent dans les zones 510, 610 et 410, est retiré sélectivement (Figure 9) pour obtenir des cavités 520, 620 et 420 surmontant les régions diffusées de source 52, de drain 62 et de grille 42.

On notera ici que la dimension des cavités est supérieure à l'ouverture de l'orifice.

Ce retrait sélectif peut se faire par tout procédé connu, par exemple au moyen d'une chimie oxydante telle qu'une solution 40 ml HNO₃ 70 % + 20 ml H₂O₂ + 5 ml HF 0,5 % ou par attaque plasma isotrope.

On procède ensuite au dépôt d'un ou de plusieurs matériaux électriquement conducteurs par des méthodes connues, ce qui permet de remplir simultanément les cavités obtenues précédemment (Figure 10) pour obtenir des régions de source 52, de drain 62, de grille 42 surmontées par des zones électriquement conductrices, par exemple des métallisations, 53, 63 et 43, et des vias de connexions 91 également électriquement conducteurs entre ces métallisations et la surface du circuit intégré.

Puisque l'ouverture des cavités est supérieure à celle des orifices, on obtient des surfaces de métallisation 43, 53, 63 supérieures à l'ouverture des vias, ce qui permet de diminuer la résistance de contact sans augmenter les dimensions latérales des vias, ce qui permet de préserver la densité d'intégration des interconnexions.

A cet égard on peut remplir les cavités 420, 520, 620 et les orifices de gravure 90 par du tungstène (W) par exemple par un dépôt chimique en phase vapeur (dépôt CVD) connu en soi, par exemple dans une fourchette de températures de 500°C à 600°C , ou bien par un dépôt du type ALD (Atomic Layer Deposition) également connu en soi, par exemple dans une fourchette de températures de 200°C à 300°C.

On peut également utiliser du cuivre (Cu), du Cobalt (Co) ou du Nickel (Ni) en utilisant un dépôt électrochimique à température ambiante. Cela étant notamment dans le cas du cuivre il est préférable de déposer préalablement une couche barrière par exemple en nitrure de titane (TiN) en utilisant un dépôt chimique en phase vapeur, ou en tantale (Ta).

On peut aussi utiliser du nitrure de tantale (TaN) en utilisant un dépôt du type ALD, par exemple dans une fourchette de températures de 200°C à 300°C.

On peut aussi utiliser du polysilicium fortement dopé en utilisant un dépôt LPCVD (dépôt CVD à basse pression) dans un four par exemple entre 700°C et 800°C, ou bien un dépôt du type ALD par exemple dans une fourchette de températures de 200°C à 300°C

On peut encore utiliser un composé métallique comportant de l'aluminium (A1) et un faible pourcentage, par exemple 5%, de silicium.

On peut encore utiliser des oxydes métalliques, comme par exemple un oxyde d'indium tel que celui connu sous la dénomination ITO (Indium Thin Oxyde).

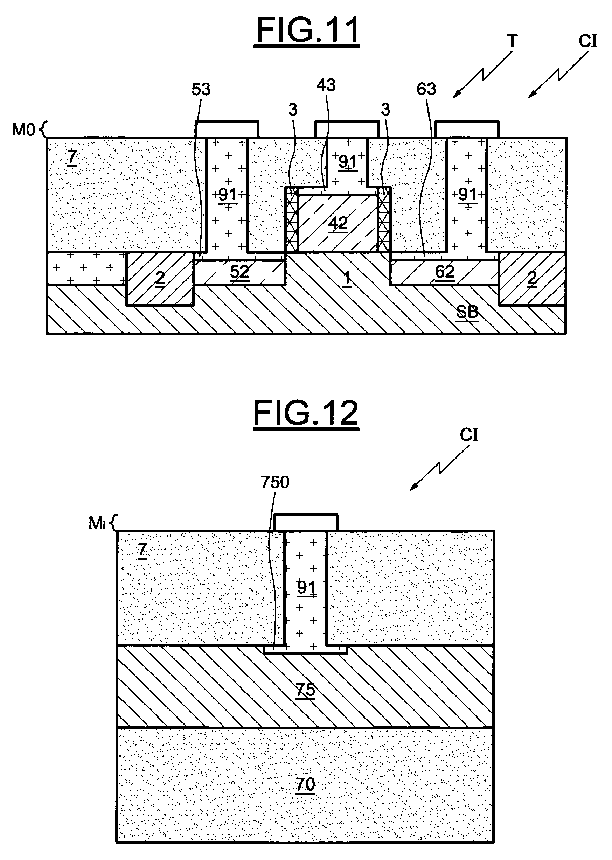

L'excès de métal, par exemple, est éliminé par exemple par un polissage mécano-chimique et un niveau de métallisation M0 est réalisé, par des moyens connus, pour obtenir le circuit intégré de la figure 11.

Sur la figure 11, on a donc représenté un circuit intégré CI comprenant un transistor selon un mode de réalisation de l'invention.

Le circuit intégré comporte un substrat SB, dans lequel des zones actives 1 ont été réalisées entre les zones d'isolations 2 du substrat. Un transistor T a été réalisé dans et sur la zone active 1 du substrat SB. Les électrodes (source 52, drain 62 et grille 42) du transistor sont recouvertes de prises de contact électriquement conductrices, par exemple entièrement métalliques et formées de métallisations surfaciques 53, 63 et 43 et de vias métalliques 91 connectés au niveau de métallisation M0.

L'invention n'est pas limitée à la réalisation de prises de contact auto alignées sur un transistor mais s'applique à tout composant passif ou actif d'un circuit intégré sur lequel il est nécessaire de prendre une prise de contact auto-alignée ou non. A titre indicatif, la figure 12 illustre schématiquement une ligne de polysilicium 75, formant une résistance, sur laquelle on a réalisé, par exemple conformément au mode de mise en oeuvre décrit ci-avant, une prise de contact entièrement métallique.

Plus précisément, cette ligne résistive de polysilicium 75, reposant par exemple sur un matériau isolant sous-jacent 70, est pourvue localement d'une prise de contact entièrement métallique. Cette prise de contact comporte comme expliqué ci avant, une zone surfacique métallique 750 et un via métallique d'inter connexion 91, ménagé au sein d'un matériau isolant supérieur 7. Le via 91 permet de relier électriquement la métallisation 750 de la résistance 75 au niveau de métallisation supérieure Mᵢ du circuit intégré. La zone surfacique métallique est obtenue selon le mode de mise en oeuvre ci avant par exemple à partir d'une implantation de Germanium localisée par un masque en résine.

## Revendications

1. Procédé de réalisation d'au moins une prise de contact sur au moins une région d'un circuit intégré, **caractérisé par le fait qu'**on modifie localement ladite région (51) de façon à créer une zone (510) s'étendant jusqu'à une partie au moins de la surface de ladite région et formée d'un matériau sélectivement éliminable par rapport au matériau de ladite région, on recouvre ladite région avec un matériau isolant (7), on forme dans le matériau isolant un orifice (90) débouchant à la surface de ladite zone, on élimine le matériau sélectivement éliminable de ladite zone à travers ledit orifice de façon à former une cavité (520) à la place de ladite zone, et on remplit ladite cavité et ledit orifice avec au moins un matériau électriquement conducteur (91).

2. Procédé selon la revendication 1, dans lequel l'ouverture de la cavité (250) est plus grande que l'ouverture de l'orifice (90).

3. Procédé selon la revendication 1 ou 2, dans lequel ladite zone (510) est une zone surfacique dont l'épaisseur est inférieure à 50 nm.

4. Procédé selon l'une des revendications précédentes, dans lequel le matériau de ladite région est un matériau à base de silicium, par exemple du silicium monocristallin ou polycristallin, et dans lequel le matériau sélectivement éliminable est un alliage de silicium et de germanium.

5. Procédé selon l'une des revendications précédentes, **caractérisé par le fait qu'**on forme ladite zone (510) par implantation de dopants, par exemple par implantation de germanium.

6. Procédé selon la revendication 5, dans lequel on forme ladite zone (510, 750) par une implantation de Germanium effectuée de manière localisée ou pleine plaque.

7. Procédé selon l'une des revendications précédentes, dans lequel on forme ledit orifice (90) par une gravure chimique ou plasma.

8. Procédé selon l'une des revendications précédentes, dans lequel on élimine le matériau de ladite zone (510) par une gravure sélective.

9. Procédé selon l'une des revendications précédentes, dans lequel ladite zone s'étend jusqu'à la totalité de la surface de ladite région.

10. Procédé selon l'une des revendications précédentes, dans lequel ladite région appartient à un composant électronique passif ou actif du circuit intégré.

11. Procédé selon l'une des revendications précédentes, dans lequel ladite région est une région de source, de drain ou de grille d'un transistor à effet de champ, ou une région d'émetteur, de collecteur ou de base d'un transistor bipolaire

12. Procédé de fabrication d'un transistor MOS, **caractérisé par le fait qu'**il comprend a) la formation des régions de grille, source et drain du transistor, et, b) la réalisation simultanée des prises de contact respectives sur les régions de source et de drain selon l'une des revendications 1 à 11, le matériau isolant dans lequel on forme lesdits orifices débouchant sur les régions de source et de drain, recouvrant la structure obtenue à l'étape a) .

13. Procédé selon la revendication 12, dans lequel on réalise également simultanément la prise de contact sur la région de grille.

14. Circuit intégré comprenant au moins une région équipée d'une prise de contact obtenue par le procédé selon l'une des revendications 1 à 13.

15. Circuit intégré selon la revendication 14, dans lequel ladite région fait partie d'un composant passif ou actif.

16. Circuit intégré selon la revendication 15, dans lequel le composant est une résistance formée d'une ligne de polysilicium.

17. Circuit intégré selon la revendication 15, dans lequel le composant est un transistor obtenu par le procédé selon la revendication 12 ou 13.
